**Europäisches Patentamt**

**European Patent Office**

**Office européen des brevets**

(11) Publication number: **0 071 161**
**B1**

## (12) EUROPEAN PATENT SPECIFICATION

(45) Date of publication of patent specification: **14.10.87**

(51) Int. Cl.⁴: **H 01 L 29/08**

(21) Application number: **82106552.1**

(22) Date of filing: **21.07.82**

(54) A transistor having the mesh emitter structure.

(30) Priority: **28.07.81 JP 118154/81**

(43) Date of publication of application:
**09.02.83 Bulletin 83/06**

(45) Publication of the grant of the patent:
**14.10.87 Bulletin 87/42**

(84) Designated Contracting States:
**DE FR GB**

(56) References cited:
**FR-A-2 011 431**
**FR-A-2 374 742**
**GB-A-2 026 236**
**GB-A-2 037 483**

(73) Proprietor: **FUJITSU LIMITED**
**1015, Kamikodanaka Nakahara-ku**
**Kawasaki-shi Kanagawa 211 (JP)**

(72) Inventor: **Nakatani, Yasutaka**
**335-6-2-404, Eda-Cho Midori-ku**
**Yokohama-shi Kanagawa 227 (JP)**
Inventor: **Kuryu, Isamu**
**1802-8-204, Nagao Takatsu-ku**
**Kawasaki-shi Kanagawa 213 (JP)**

(74) Representative: **Seeger, Wolfgang, Dipl.-Phys.**
**European Patent Attorney Bereiteranger 15**
**D-8000 München 90 (DE)**

Courier Press, Leamington Spa, England.

# Description

This invention relates to a semiconductor device, particularly to a bipolar type transistor having a meshed emitter region.

As a bipolar type high power, high frequency transistors, overlay type transistors, mesh emitter transistors and ring emitter transistors have been put into practical use.

Overlay type transistors have a plurality of emitter regions formed in the form of lands in the vicinity of base region surface and said plurality of emitter regions are connected in parallel by the electrodes.

Mesh emitter transistors have meshed emitter regions formed in the vicinity of base region surface and the electrodes are led from the intersections of said meshed portions.

Ring emitter transistors have a plurality of ring-shaped emmitters deposited in the form of lands in the vicinity of base region surface and said ringshaped regions are connected in parallel by the electrodes.

Namely, in these high power, high frequency transistors, the periphery of the emitter region is made longer, as much as is possible, in the limited base area in order to realize higher power and a higher frequency characteristic.

Mesh emitter transistors have a larger emitter size in a base region than a ring emitter type transistors, as known from GB—A—2 037 483, or as comb-shaped emitter type transistors, as known from GB—A—2 026 236. This means that the size of the interface area between the base region and the emitter region is so large that the emitter current becomes large, consequently the transistor has a large emitter current efficiency based on the same chip size.

However, even with mesh emitter transistors there is the destruction problem according to the reverse-bias during turn-off.

This invention relates to an improvement in high power and high frequency transistors having said mesh emitter structure.

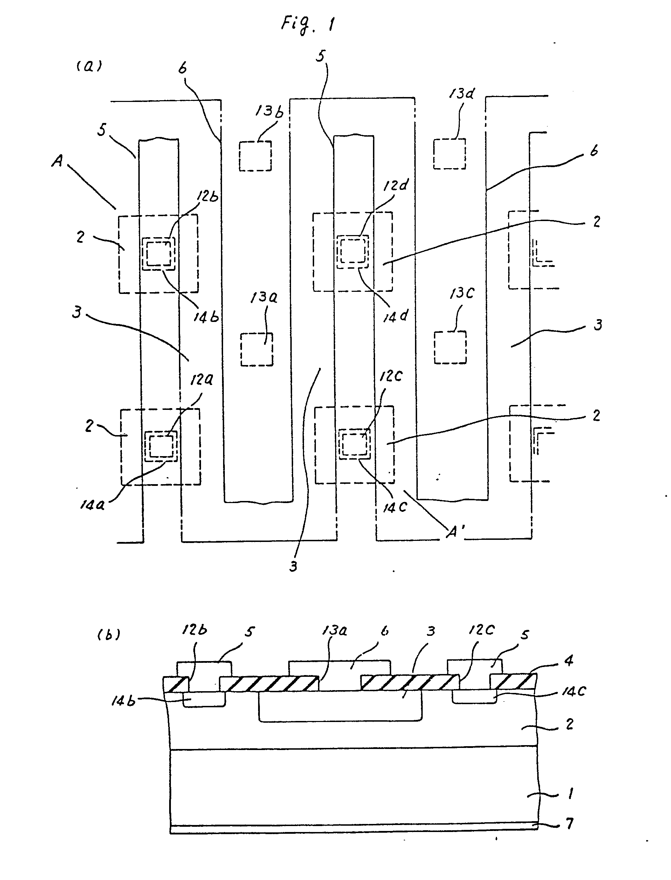

Such mesh emitter transistors have a structure as shown in Fig. 1. Fig. 1(b) is the sectional view along the line A—A' in Fig. 1(a).

In this figure, 1 is the n type silicon substrate forming the collector region; 2 is the P type base region which is formed by diffusing the acceptor impurity selectively or entirely into the one main surface of said silicon substrate 1; 3 is the $n^+$ type emitter region formed by diffusing selectively the donor impurity into said P type base region 2. Such $n^+$ type emitter region 3 has the mesh type plane surface.

Moreover, 4 is the insulating film consisting of the silicon dioxide ($SiO_2$) etc. covering the surface of silicon substrate; 5 is the base leadout electrode; 6 is the emitter leadout electrode; 7 is the collector electrode.

In addition, 12a, 12b are base electrode windows provided on the insulating film 4 and 13a, 13b are emitter electrode windows provided on the insulating film 4. 14a, 14b, ... are $P^+$ type base contact region (base compensating diffused region).

It is often attempted to use a mesh emitter transistor having such structure in a switching regulator, DC—DC convertor because of its high speed switching characteristic.

However, for application in such a switching regulator and DC—DC convertor, said mesh emitter transistor is required to have a high breakdown voltage and a large safe operating area because it operates on a heavy current.

Consequently, the emitter strip of said mesh emitter transistor is widened in view of reducing a current density per unit area of the emitter region. However, when the emitter strip is widened, the sectional area of base region is reduced due to enlargement of said emitter region and a resistance of base region under the emitter region 3, namely an internal base resistance rbb' in the direction from almost the center of the intersections of emitter strip to the base contact region 14, in other words, in the direction along the line A—A' of Fig. 1(a), increases.

Such increase of internal base resistance results in deterioration of switching speed of said mesh emitter transistor and moreover it causes a part of charges to remain just under the emitter strip on the occasion of the switching operation, particularly during the turn-off, thereby allowing concentration of a current and resultant breakdown of said mesh emitter transistor.

It is an object of the present invention to provide a semiconductor device having a mesh emitter structure which can eliminate disadvantages of conventional mesh emitter transistors.

It is another object of the present invention to provide a semiconductor device having a mesh emitter structure which can eliminate the disadvantages of conventional mesh emitter transistors, which has a high speed switching characteristic and which also has a high breakdown voltage and a large safe operating area.

Accordingly, the present invention provides a semiconductor device according to claim 1.

As the means for substantially making inactive electrically the center area of intersections of such mesh emitter region, following can be employed.

i. A part of base region is exposed at the inactive region in the center of intersections in said emitter region.

ii. The opposing conductivity type region is selectively deposited at the center of intersections in said emitter region.

Various examples of semiconductor devices in accordance with this invention will now be described and contrasted with earlier conventional devices with reference to the accompanying drawings; in which:-

Fig. 1 is the plan view (a) and sectional view (b) of the conventional semiconductor device having the mesh emitter structure.

Fig. 2 is the plan view (a) and sectional view (b) showing the structure of a semiconductor device having the mesh emitter structure in relation to a first embodiment of the present invention.

Fig. 3 is the plan view of the structure of a semiconductor device having the mesh emitter structure in relation to a second embodiment of the present invention.

Fig. 4 is the plan view of the structure of a semiconductor device having the mesh emitter structure in relation to a third embodiment of the present invention.

Fig. 5 is the plan view (a) and sectional view (b) of the structure of a semiconductor device having the mesh emitter structure in relation to a fourth embodiment of the present invention.

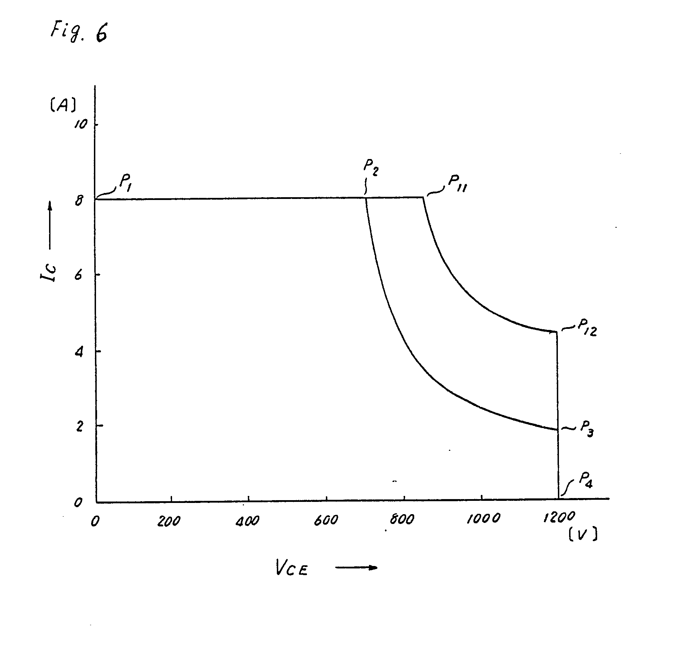

Fig. 6 shows the safe operating areas of a conventional semiconductor device and the semiconductor device in relation to the present invention.

Fig. 1 has been described above

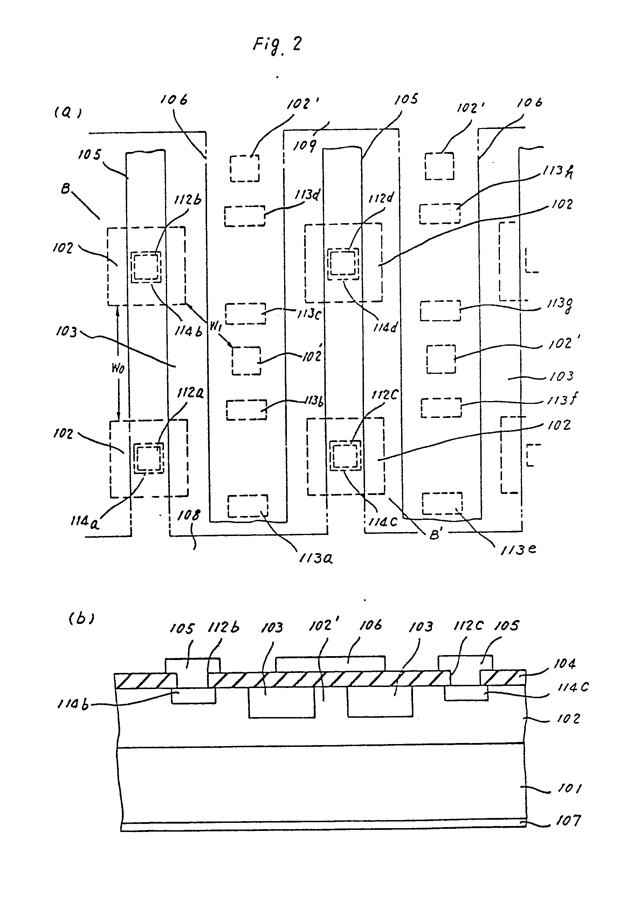

Fig. 2 shows the structure of the first embodiment in relation to the semiconductor device of the present invention. Fig. 2(b) shows the sectional view of (a) along the line B—B' in Fig. 1.

In the same figure, 101 is the n type silicon (Si) substrate forming the collector region; 102 is the P type base region formed by diffusing selectively or entirely the acceptor impurity, for example, boron (B) into the one main surface of said silicon substrate 101; 103 is the $n^+$ type emitter region formed by selectively diffusing the donor impurity, for example, the phosphorus (P) into said P type base region 102.

In the case of the first embodiment, such $n^+$ type emitter region 103 has the mesh plane surface and said emitter region is not formed at the center of the intersections of mesh structure and a part 102' of the base region 102 is exposed. Namely, the intersecting areas of the emitter region 103 are hollowed.

104 is the insulating film consisting of the silicon dioxide ($SiO_2$) which covers the surface of silicon substrate, 105 is the base leadout electrode consisting of the aluminium (Al), 106 is the emitter leadout electrode also consisting of the aluminium and 107 is the collector electrode. A plurality of base leadout electrodes 105 are connected in common to the base electrode pad 108, and a plurality of emitter leadout electrodes 106 are also connected in common to the emitter electrode pad 109. Moreover, 112a, 112b, ... are base electrode windows provided in the insulating film 104; 113a, 113b ... are emitter electrode windows provided also in the insulating film 104. Moreover, 114a, 114b, ... are $p^+$ type base contact region (base compensating diffused region).

In such a mesh emitter transistor, the emitter region is hollowed at the center of intersections in the mesh emitter region 103 as explained previously and thereby a part 102' of the base region is exposed.

According to such structure, a base resistance in said base region 102' is sufficiently low because said base region 102' is thick and therefore a base resistance just under the emitter region 103 along the line B—B' is substantially equal to a resistance of base region 102 just under said emitter region 103.

Therefore, according to such structure, an internal base resistance rbb' can drastically be reduced as compared with that of said conventional structure.

With such reduction of an internal base resistance rbb', a semiconductor device having such mesh emitter structure is capable of realizing improvement in the switching speed. Further, when said internal base resistance rbb' is reduced, the amount of charges which remain in the area just under the emitter region 103 at the time of turn-off and accumulated therein can also be reduced, making less the current concentration at the intersections of said emitter region 103.

Moreover, a current concentrated at the intersections in the emitter region at the time of turn-off is diverged to the circumference of the emitter region 103 which is in contact with the base region 102'.

Therefore, different from said conventional structure, a current is not concentrated at the intersections of the mesh emitter region, the safe operating area of said semiconductor device can be improved and the fall time when the device turns to OFF from ON can also be shortened.

Namely, a mesh emitter transistor having the structure shown in Fig. 2 is formed, wherein

the specific rsistance of n type collector region 101 is 100 ohm-cm,

the surface impurity concentration of the p type base region 102 is $5\times10^{18}$ atoms/$cm^3$,

The depth of p type base region 102 is 15 μm,

the surface impurity concentration of $n^+$ type emitter region 103 is $1\times20^{21}$ atoms/$cm^3$,

the depth of $n^+$ type emitter region 103 is 7, 5 μm.

the stripe width of $n^+$ type emitter region 103 is 80 μm,

the size of aperture of p type base region 102 is 70 μm in length×70 μm in width,

the size of apearature of p type base region 102' is 60 μm in length×60 μm in width,

the thickness of insulating film is 2 μm,

the thickness of base leadout electrode 105 is 3 μm,

the width of base leadout electrode is 20 μm,

the thickness of emitter leadout electrode 106 is 3 μm, the width of emitter leadout electrode 106 is 25 μm.

On the other hand, there is the mesh emitter transistor of the conventional structure shown in Fig. 1, wherein the specific resistance of the collector, surface impurity concentration and depth of the base region, surface impurity concentration and depth of the emitter region are equal to those of a transistor having the structure shown in Fig. 2.

Thus, the safe operating area in the reverse bias has been measured under the load of inductance (L) for the mesh emitter transistor of conventional structure and that of the present invention.

The safe operation current of both transistors has been obtained under the condition that the load inductance is 1 mH and collector-emitter voltage is 900V. As a result, the safe operation current of the conventional mesh emitter transistor was 3 ampere, while that of the mesh emitter transistor of the present invention was 6 ampere. Namely, the safe operating area can be increased outstandingly by the present invention.

Fig. 8 shows the reverse bias safe operating areas of such conventional mesh emitter transistor and the mesh emitter transistor of the present invention.

In this figure, a collector current (Ic) is plotted on the vertical axis, while the collector-emitter voltage ($V_{CE}$) is plotted on the horizontal axis. The measuring conditions are as follows; a load inductance value is 1 mH, a collector voltage is 60 V, a base current ($IB_2$) for pulling to OFF from ON is −1 ampere, a base voltage for pulling to OFF from ON is about 5 V.

In Fig. 8 the area enclosed by the X axis, the Y axis, the points $P_1$, $P_2$, $P_3$ and $P_4$ is the reverse bias safe operating area of the conventional mesh emitter transistor, and the area enclosed by the X axis, the Y axis, the points ($P_1$, $P_{11}$, $P_{12}$, $P_4$ is the reverse bias safe operating area of the mesh emitter transistor of the present invention.

In addition, the fall time of said conventional mesh emitter transistor was 120 ns, while the fall time of the mesh emitter transistor of the present invention was 70 ns. Namely, the present invention has realized a drastic improvement in the switching characteristic.

Accordingly, the present invention is capable of providing a semiconductor device ensuring excellent high speed switching characteristic and a large safe operating area which could not be obtained in said conventional mesh emitter transistor.

In the structure shown in Fig. 2, it is essential to set the relation as follow.

$$W_1 > 1/2 \cdot W_o$$

where, $W_1$: is the width of emitter region between the portion of the base region exposed centrally of the intersections of the stripes and a base contact region, and $W_o$: is the width of emitter stripe

By setting $W_o$ and $W_1$, it can be prevented that charges are left in the area just under the emitter stripe, except for that under the intersections at the time of turn-off operation.

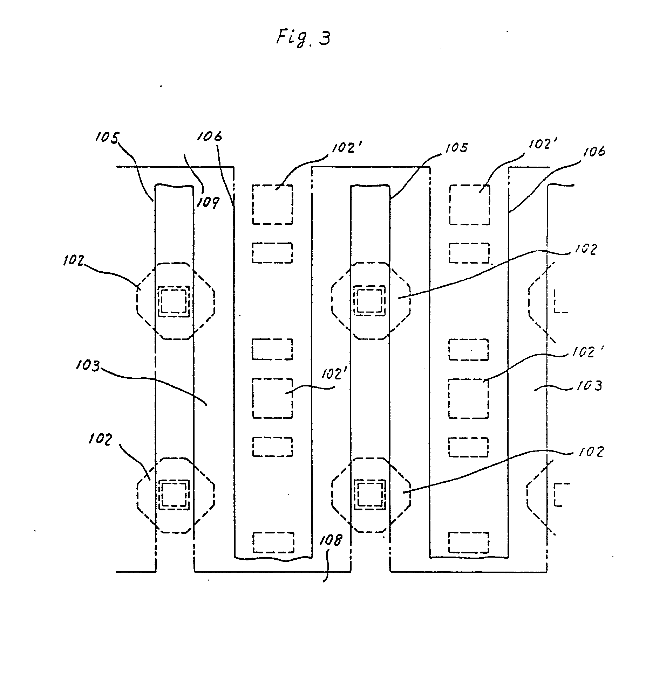

Fig. 3 is the second embodiment of the semiconductor device of the present invention. In this figure, the portions corresponding to those in the embodiment of Fig. 2 are given the same numbering or symbols.

In the case of this embodiment, the intersections of mesh emitter region are widely located in the direction to base electrode window 112b.

The emitter region increases its area because it is widely arranged in the direction to the base electrode window, allowing an emitter current to increase. Thereby a semiconductor device for a higher power can be formed.

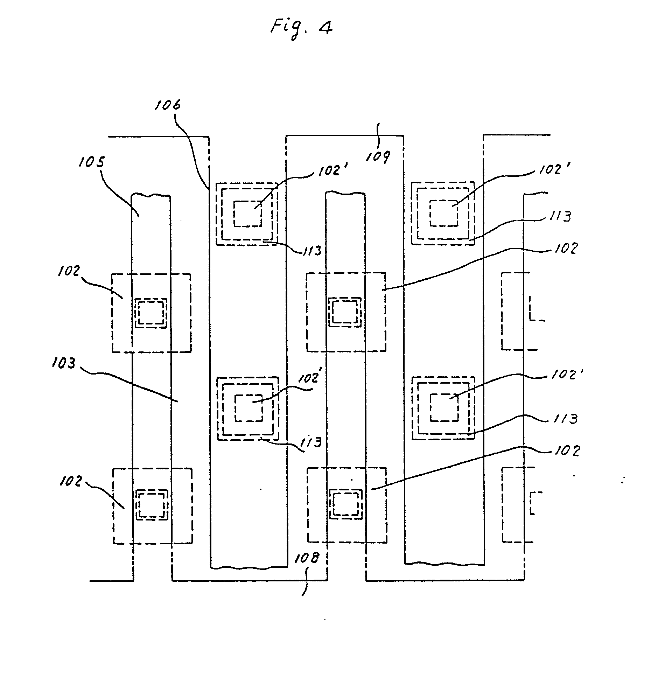

Fig. 4 is the third embodiment of the semiconductor device of the present invention. In this figure, the portions corresponding to those in Fig. 2 are given the same numbering or symbols.

In this embodiment, the emitter electrode window 113 is formed on the insulating film 104 in such a manner as to surround the base region 102'.

With such structure of emitter electrode window, connected between the emitter region and emitter the electrode can be made with a lower resistance.

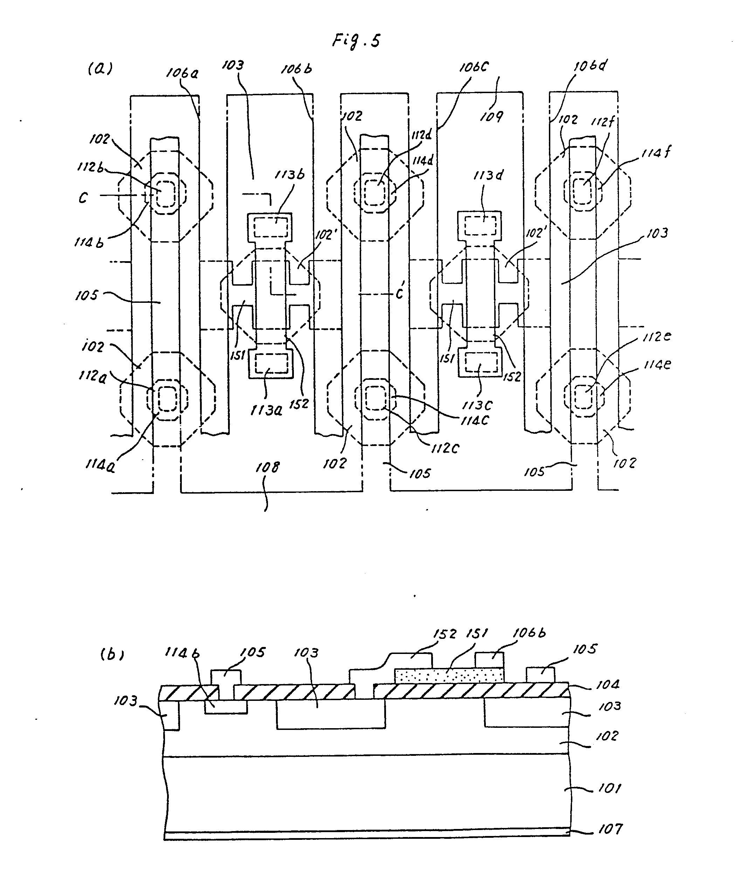

Fig. 5 is the fourth embodiment of the semiconductor device of the present invention. In this figure, the portions corresponding to those in Fig. 2 are given the same numbering or symbols.

In this embodiment, the emitter ballast resistors are respectively deposited at the intersections of mesh emitter region 103 and the emitter leadout electrode 106 is connected to the emitter region 103 via said emitter ballast resistors.

In the embodiment shown in Fig. 5, the base region 102' exposed at the center of intersections in the mesh emitter region 103 has the octagonal plane surface and the exposed area of the base region 102 also has the octagonal shape.

In Fig. 5, 151 is the emitter ballast resistor, consisting, for example, of the polycrystalline silicon containing impurity such as phosphorus or nichrome (Ni-Cr) etc.; 152 is the connecting conductor consisting of aluminium, for example, connecting between said emitter ballast resistor 151 and the emitter region 103 via the emitter electrode window 113a, 113b.

As shown in this figure, the ballast resistor 151 is provided and connected with the emitter electrodes (for example 106a and 106b) at both ends and also provided and connected with the connecting conductor 152 at its center area. A resistance value of the ballast resistor 151 is determined by selecting the thickness, width or impurity concentration.

In such a structure, said ballast resistor 151 is formed by deposition of the polycrystalline silicon including the phosphorus (P), for example, and succeeding patterning process utilizing the photolithography technique. After such ballast resistor is formed, the base leadout electrode, emitter leadout electrode and connecting conductor are formed by deposition of aluminium and successive patterning process in accordance with the ordinary planar bipolar transistor producing processes.

In case said ballast resistors 151 are arranged at the intersections of the mesh emitter region 103, in order to give a connection by said ballast resistor between the emitter leadout electrode and the emitter region, the emitter region operates uniformly in any portion even when it operates on any heavy current, not allowing concentration of a current to a particular portion.

Therefore, said semiconductor device does not result in breakdown due to the secondary breakdown phenomenon, assuring an excellent high frequency characteristic, a high speed switching characteristic and a large safe operating area.

Moreover, it is not required to newly provide the region for depositing the ballast resistor and as a result density is not deteriorated.

In the structure shown in Fig. 5, the polycrystalline silicon layer, for example, forming the ballast resistor 151 is partly placed in contact with the emitter region 106. But the present invention is not limited thereto. It is also possible to allow the resistance material forming such ballast resistor to be extended under the emitter electrode 106 and the emitter electrode pad 109. Such resistance material extending thereunder improves flatness in the semiconductor substrate surface and raises accuracy of photo-etching and production yield on the occasion of forming the emitter electrode 106 and emitter electrode pad 109.

A semiconductor device of the present invention indicated in Fig. 2 to Fig. 5 can be formed with ordinary planar type bipolar transistor production method.

At this time, impurity concentration and depth of the base region, emitter region and collector region, moreover thickness of surface insulating film and thickness of electrode material are selected by the power and frequency of the pertinent semiconductor device.

According to the present invention as explained above, in a semiconductor device having the mesh emitter structure, a semiconductor device having the high speed switching characteristic and a large safe operating area can be realized by exposing the base region without forming the emitter region at the center of intersections in the mesh emitter region. Therefore, reduction in size and weight of switching power supply can be realized by introducing such semiconductor device into the switching power supply.

## Claims

1. A semiconductor device comprising a collector region (101) having a first conductivity type, a base region (102) formed in said collector region having a second conductivity type and a mesh emitter region (103) of the first conductivity type formed in said base region (102) characterized in that the mesh emitter region comprised mutually intersecting stripes thereby forming a mesh shape and in that inactive regions are only located substantially centrally of the intersections of the stripes of the mesh emitter region and in that

$$W_1 > 1/2 \cdot W_o$$

where, $W_1$: is the width of emitter region between the portion of the base region exposed centrally of the intersections of the stripes and a base contact region, and
$W_o$: is the width of the emitter stripe.

2. A semiconductor device as claimed in claim 1, wherein ballast resistors (151) are deposited via an insulating film (104) on the inactive region provided at the center of intersections in said mesh emitter region (103), one end of said ballast resistor (151) is connected to the emitter region (103), while the other end is connected to an emitter electrode (106a, 106b).

## Patentansprüche

1. Halbleitervorrichtung mit einem Kollektorbereich (101), der von einem ersten Leitfähigkeitstyp ist, einem Basisbereich (102), der in dem genannten Kollektorbereich gebildet ist und von einem zweiten Leitfähigkeitstyp ist, und einem Maschenemitterbereich (103) vom ersten Leitfähigkeitstyp, der in dem genannten Basisbereich (102) gebildet ist, dadurch gekennzeichnet, daß der Maschenemitterbereich sich wechselseitig kreuzende Streifen umfaßt, wodurch eine Maschenform gebildet wird, und daß inaktive Bereiche lediglich im wesentlichen zentral zu den Überschneidungen der Streifen des Maschenemitterbereiches angeordnet sind und daß

$$W_1 > 1/2 \cdot W_o$$

wobei $W_1$: die Breite des Emitterbereichs zwischen dem Anschnitt des Basisbereichs, der zentral zu den Überschneidungen der Streifen exponiert ist, und einem Basiskontaktbereich ist, und
$W_o$: die Breite des Emitterstreifens ist.

2. Halbleitervorrichtung nach Anspruch 1, bei der die Ballastwiderstände (151) über einen isolierenden Film (104) auf dem inaktiven Bereich deponiert sind, der bei dem Zentrum der Überschneidungen in dem genannten Maschenemitterbereich (103) vorgesehen ist, wobei ein Ende des Ballastwiderstandes (151) mit dem Emitterbereich (103) verbunden ist, während das andere Ende mit einer Emitterelektrode (106a, 106b) verbunden ist.

## Revendications

1. Dispositif à semiconducteur comportant une région de collecteur (101) ayant un premier tupe de conductivité, une région de base (102) formée dans le région de collecteur et ayant un second type de conductivité et une région d'émetteur en forme de maille (103) du premier type de conductivité formée dans la région de base (102), caractérisé en ce que la région d'émetteur en forme de maille comprend des bandes se coupant mutuellement par lesquelles est constituée une forme de maille et en ce des régions inactives ne sont placées essentiellement qu'au centre des intersections des bandes de la région d'émetteur en forme de maille et en ce que

$$W_1 > 1/2 \cdot W_o$$

où, $W_1$: est la largeur de la région d'émetteur entre la partie de la région de base exposée au centre des intersections des bandes et une région de contact de base,
et $W_o$: est la largeur de la bande d'émetteur.

2. Dispositif à semiconducteur selon la revendication 1, dans lequel des résistances de charge (151) sont déposées par un film isolant (104) sur la région inactive prévue au centre des intersections dans la région d'émetteur en forme de maille (103), une extrémité de la résistance de charge (151) est connectée à la région d'émetteur (103), alors que l'autre extrémité est connectée à une électrode d'émetteur (106a, 106b).

## Fig. 1

(a)

(b)

Fig. 2

(a)

(b)

Fig. 3

Fig. 4

Fig.5

(a)

(b)

Fig. 6